# EUROPÄISCHE PATENTSCHRIFT

(11) **EP 0 497 104 B1**
(45) Veröffentlichungstag und Bekanntmachung des Hinweises auf die Patenterteilung: **05.04.1995**
(21) Anmeldenummer: 92100285.3
(22) Anmeldetag: 09.01.1992
(51) Int. Cl.: H01L 21/00

(54) **Magazin zur Halterung von scheibenförmigen Werkstücken, insbesondere Halbleiterscheiben, bei der nasschemischen Oberflächenbehandlung in Flüssigkeitsbädern**
Container for holding workpieces, in form of disks, in particular semiconductor wafers, in a chemical surface treatment with liquid baths
Magasin pour contenir des pièces en forme de disques, en particulier des disques semi-conducteurs, dans un traitement de surface chimique en bains liquides

(30) Priorität: 01.02.1991 DE 4103084
(43) Veröffentlichungstag der Anmeldung: 05.08.1992
(73) Patentinhaber: Wacker-Chemitronic Gesellschaft für Elektronik-Grundstoffe mbH, D-84489 Burghausen (DE)
(72) Erfinder: Stadler, Maximilian, Dr. Dipl.-Ing., W-8261 Haiming (DE); Schwab, Günter, Dipl.-Ing., W-8269 Burgkirchen (DE); Romeder Peter, D-8263 Burghausen (DE)

(56) Entgegenhaltungen:
- DE-A- 2 526 052
- DE-A- 3 306 331
- FR-A- 2 295 567
- IBM TECHNICAL DISCLOSURE BULLETIN. Bd. 8, Nr. 11, April 1966, NEW YORK US Seiten 1644-1645; J.R. HAUSE: 'SEMICONDUCTOR WAFER BARREL'

## Beschreibung

### Magazin zur Halterung von scheibenförmigen Werkstücken, insbesondere Halbleiterscheiben, bei der naßchemischen Oberflächenbehandlung in Flüssigkeitsbädern

Die Erfindung betrifft ein Magazin zur Halterung von scheibenförmigen Gegenständen, insbesondere Halbleiterscheiben, bei der naßchemischen Oberflächenbehandlung in Flüssigkeitsbädern, mit einem mit Öffnungen zum Ein- und Austritt der Badflüssigkeit und Mitteln zur Einbringung in ein Flüssigkeitsbad versehenen Gehäuse und einem in das Gehäuse einführbaren Einsatz zur Halterung der zu behandelnden Werkstücke in unmittelbarer, dichter flächiger Gegenüberstellung.

Es ist bekannt, daß scheibenförmige Substrate, insbesondere einkristalline und polykristalline Halbleitersubstrate aus beispielsweise Silicium, Germanium und Verbindungshalbleitern wie Galliumarsenid und Indiumphosphid oder oxidischen Materialien wie Quarz, Rubin, Spinell oder Granat, beispielsweise Gallium-Gadolinium-Granat, wie sie zumeist durch Zersägen stabförmiger Werkstücke hergestellt werden, während des Herstellungsvorgangs und vor allem vor der Weiterverarbeitung zu elektronischen Bauelementen vielerlei Reinigungs- und Ätzbehandlungen unterworfen werden, die beispielsweise der Entfernung zerstörter Kristallbereiche von der Oberfläche, oder auch der chemischen Veränderung der Oberfläche, insbesondere etwa durch Oxidation, Oxidschichtentfernung oder Hydrophilierung, dienen können.

Wesentlich ist bei solchen Behandlungsschritten, daß die Reinigungs- und Ätzlösungen bei der Reaktion gleichmäßig und homogen über die gesamte Oberfläche der Scheiben verteilt werden. Dabei sollen die genannten Reinigungs- und Ätzoperationen auch auf der gesamten Scheibenoberfläche mit der im wesentlichen gleichen Geschwindigkeit ablaufen, so daß beispielsweise ungleichmäßige Ätztiefen vermieden werden. Nur so können z. B. saubere Oberflächen mit einer möglichst geringen Ebenheitsvariation und hoher Oberflächenparallelität erhalten werden, wie sie von den Herstellern elektronischer Bauelemente für die eingesetzten Halbleiterscheiben gefordert werden.

Um eine derart gleichmäßige Behandlung der Oberflächen mit der Reinigungs- und Ätzlösung zu erreichen, sind im Stand der Technik bereits die verschiedensten Vorrichtungen wie etwa in DE-A-33 06 331 und DD-A-220 859 bekanntgeworden. So besteht eine der dort beschriebenen Ausführungsvariante darin, daß das zu ätzende Substrat an einer Oberfläche mit einem Saugkopf gehalten wird, während gegenüber der anderen, zu ätzenden Oberfläche durch die Rotation von Scheiben, die mit Strömungskanälen versehen sind, eine Durchmischung der Lösung erreicht wird. Dabei ist jedoch nur die Bearbeitung einer Scheibenoberfläche möglich.

Um jedoch beide Oberflächen bearbeiten zu können, ist in der DD-A-220 859 eine Anordnung angegeben, bei der die Scheiben in einem Ätzkorb ähnlich einem Käfig näherungsweise parallel und mit regelmäßigen und gleichmäßigen Abständen zueinander und frei beweglich gehalten werden, so daß eine Bewegung der zu ätzenden Scheiben relativ zum Ätzkorb möglich ist. Die Rotation des Ätzkorbes führt dabei zu einer Durchmischung der Lösung und gleichzeitig zu einer Bewegung der Scheibe relativ zum Ätzkorb, wodurch die Auflagepunkte der Scheibe auf den Stäben des Ätzkorbes ständig verändert werden. Diese Ausführungsform erfordert aber, um die Durchmischung der Behandlungsflüssigkeit zu erhöhen, die Zugabe ebenfalls frei beweglicher, glatter aber unrund geformter Distanzscheiben, die sich ebenfalls relativ zum Ätzkorb und den zu bearbeitenden Scheiben bewegen. Dabei wird jedoch gleichzeitig die Gefahr der mechanischen Beschädigung der Scheiben, der Kontamination durch das Material der Distanzscheiben oder des Ätzkorbes oder eines ungleichmäßigen Auftrags der Ätzflüssigkeit, falls die Distanzscheiben direkt auf der Scheibenoberfläche der zu bearbeitenden Scheiben aufliegen, beträchtlich erhöht.

Erfolgt, wie aus DE-A-33 06 331 bekannt, die Durchmischung der Behandlungsflüssigkeit lediglich durch die Scheiben selbst oder durch die Haltestangen am Rand der Scheiben, ergibt sich in diesem Randbereich eine stärkere Durchmischung und größere Abtragrate, die zu linsenförmigem Querschnitt der Scheiben führt. Oft lassen sich auch ringförmige Verdickungen feststellen, die durch stärkeren Abtrag am Scheibenrand oder im Scheibeninneren entstehen.

Letztlich sind daher bei der Herstellung von Halbleiterscheiben, insbesondere bedingt durch die ungünstige Halterung der Scheiben, die herkömmlichen Ätzverfahren mit einer Verschlechterung der Scheibengeometrie verbunden. Dieser Nachteil verstärkt sich mit zunehmendem Durchmesser der Substrate und kommen insbesondere bei Durchmessern >100 mm zum Tragen, wie sie in der Bauelementeherstellung mehr und mehr gefordert werden.

Der Erfindung liegt daher die Aufgabe zugrunde, eine Halterung für die Behandlung von Scheiben in Flüssigkeitsbädern bereitzustellen, mit der eine beidseitige, gleichmäßige Behandlung mit der Badflüssigkeit möglich ist, ohne daß inhomogene Reaktionsverläufe auftreten. Insbesondere soll bei Ätzprozessen die Qualitätsverschlechterung möglichst gering gehalten werden, so daß die Herstellung von Scheiben mit hochgradig ebenen und flächenparallelen Oberflächen möglich ist.

Diese Aufgabe wird gelöst durch einen Einsatz, welcher gekennzeichnet ist durch
a) mindestens drei parallele, jeweils eine Ebene aufspannende Führungsstrebenbündel 12, jedes bestehend aus mindestens zwei Führungsstreben 7, nämlich einer Hauptführungsstrebe 9 und einer mit ihr Verknüpften Nebenführungsstrebe 10, und
b) mindestens drei Distanzstreben 8, die paßgerecht zur Innenfläche des Gehäusezylinders angeordnet sind, und die die mindestens drei Führungsstrebenbündel am äußeren, dem Gehäuse zugewandten Ende der Führungsstreben so fixieren, daß die Zwischenräume zwischen den Ebenen der Führungsstreben bündel die Aufnahme der zu halternden scheibenförmigen Werkstücke gestatten, wobei je Führungsstrebenbündel mindestens eine Hauptführungsstrebe 9 zwei Distanzstreben verbindet und mindestens eine Nebenführungsstrebe 10 die Hauptführungsstrebe mit einer weiteren Distanzstrebe verbindet und die Mehrzahl der Führungsstreben geknickt oder gebogen sind,
c) an den Verknüpfungsstellen 13 die Führungsstreben in höchstens drei Richtungen auseinanderlaufen,
d) die Verknüpfungsstellen der Führungsstreben nicht auf der Längsachse des zylindrischen Gehäuses liegen,
e) der Durchmesser des Einsatzes 1,1 bis 1,9 mal dem Durchmesser der zu halternden scheibenförmigen Werkstücke entspricht
f) der Abstand benachbarter Distanzstreben zwischen mindestens zwei der Distanzstreben größer oder gleich dem Durchmesser der zu halternden scheibenförmigen Werkstücke ist und zwischen mindestens zwei der Distanzstreben kleiner als der Radius der zu halternden Werkstücke ist, und
g) die innere lichte Weite zwischen zwei Führungsstrebenbündelebenen mindestens zweimal der Dicke der zu halternden scheibenförmigen Werkstücke entspricht.

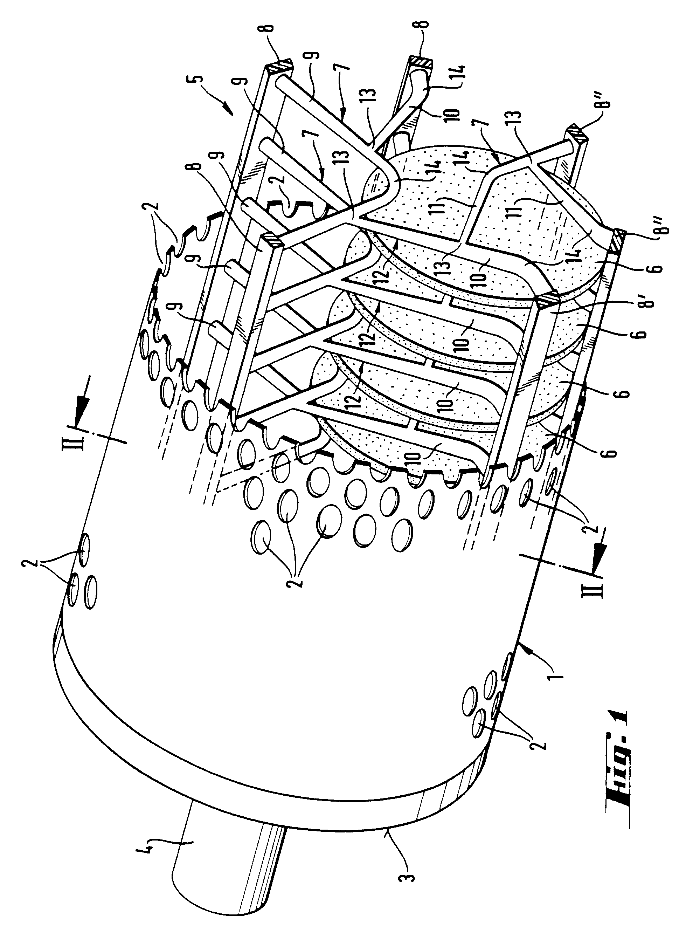

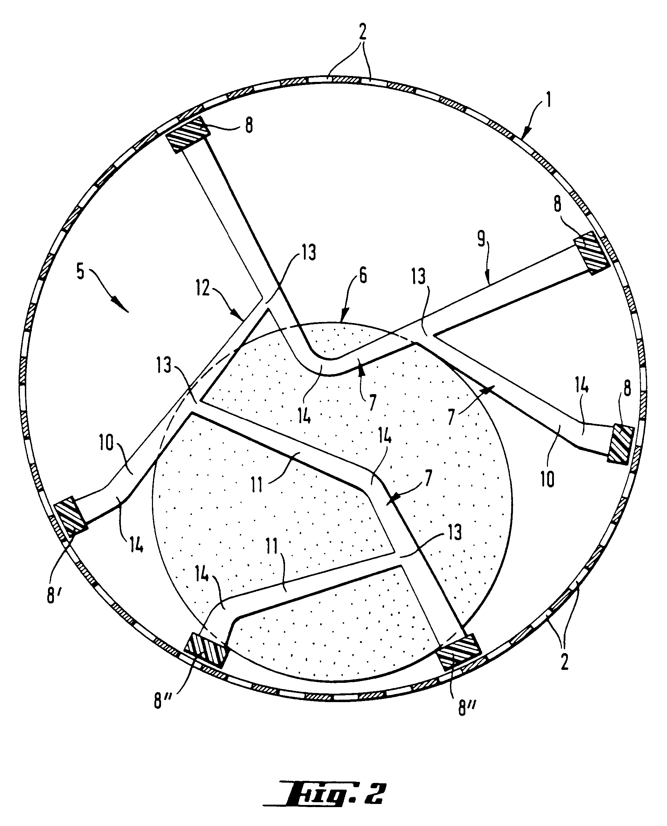

Die Erfindung wird im folgenden anhand des in den Figuren 1 und 2 dargestellten Ausführungsbeispiels näher erläutert. Es zeigt
Fig. 1 in perspektivischer Teildarstellung eine mögliche Ausführungsform eines erfindungsgemäßen Ätzmagazins bestehend aus Einsatz und Gehäuse
Fig. 2 einen Querschnitt in der Ebene II-II des in Fig. 1 dargestellten Einsatzes

Das in Figur 1 dargestellte Magazin dient vorteilhaft zur Halterung, Einbringung und Bewegung von scheibenförmigen Werkstücken, wie etwa hochgradig reinen Halbleiterscheiben, insbesondere Siliciumscheiben in Bäder, die insbesondere Ätzlösungen enthalten. Das Magazin besteht aus einem vorzugsweise zylinderförmigen Gehäuse 1 mit Durchlaßöffnungen 2 für den Durchtritt der Flüssigkeit und einem stirnseitigen Verschlußdeckel 3 mit Mittel 4, beispielsweise Zapfen, zur Einbringung in ein Flüssigkeitsbad sowie einem Einsatz 5 zur Halterung der scheibenförmigen Werkstücke 6 in unmittelbarer, dichter flächiger Gegenüberstellung im Gehäuse 1 näherungsweise senkrecht zur Achse des Gehäusezylinders.

Als scheibenförmige Werkstücke 6 werden insbesondere runde Scheiben bearbeitet. Möglich ist auch die Bearbeitung von teilweise an der Peripherie abgeflachten, annähernd runden Scheiben. Solche, teilweise auch mehrfach an der Peripherie abgeflachten Scheiben sind in der Halbleitertechnologie üblich, um Dotierungsgrad und Kristallorientierung zu kennzeichnen. Das Verfahren schließt jedoch auch die Bearbeitung anderer Scheibenformen, beispielsweise nur teilweise runder, ovaler oder polygonaler Scheiben, nicht aus.

Der Einsatz 5 setzt sich zusammen aus Führungsstreben 7 und Distanzstreben 8, die mit den Enden der Führungsstreben verbunden sind, und zwar in einer bevorzugten Ausführungsform so, daß alle äquidistant von der Achse des Gehäusezylinders auf dem Zylindermantel angeordnet sind. Als Durchmesser des Gehäuses hat sich das 1,1 - 1,9 fache des Scheibendurchmessers als günstig erwiesen.

Fig. 2 zeigt einen Querschnitt einer bevorzugten Ausführungsform des Einsatzes 5, bei der mindestens eine Hauptführungsstrebe 9 zwei Distanzstreben 8 verbindet. Es sind aber auch Ausführungsformen mit zwei oder mehr Hauptführungsstreben denkbar. Mindestens eine Nebenführungsstrebe 10 verbindet die Hauptführungsstrebe 9 mit einer weiteren Distanzstrebe 8′. Nach dem Baumprinzip können auch von jeder Nebenführungsstrebe 10 weitere Nebenführungsstreben 11 zu Distanzstreben 8˝ laufen. Die Summe der Haupt- und Nebenführungsstreben, die in einer Ebene liegen und zur einseitigen Führung einer Scheibenfläche dienen, werden im folgenden als Führungsstrebenbündel 12 bezeichnet.

Die Zahl der Nebenführungsstreben und Hauptführungsstreben, die an den Verknüpfungspunkten 13 verbunden sind, ebenso wie der Distanzstreben ist zwar grundsätzlich nach oben nicht begrenzt, sollte jedoch zweckmäßig so gering wie möglich gehalten werden, um die Zahl der Kontaktpunkte mit den Scheibenoberflächen zu verringern. Im mindesten sind eine Hauptführungsstrebe und eine Nebenführungsstrebe nötig.

Gleichartige Enden der Führungsstreben werden durch eine Distanzstrebe verbunden, so daß in der Ausführungsform mit einer Haupt- und einer Nebenführungsstrebe drei Distanzstreben nötig sind.

In einer bevorzugten Ausführungsform liegt eine Hauptführungsstrebe, zwei Nebenführungsstreben, die die Hauptführungsstreben mit Distanzstreben verbinden, und zwei Nebenführungsstreben, die andere Nebenführungsstreben mit Distanzstreben verbinden, vor. In der Regel ist die Zahl der Distanzstreben gleich der Summe der Zahlen der Hauptführungsstreben und der Nebenführungsstreben plus 1, in diesem bevorzugten Ausführungsbeispiel liegen dann sechs Distanzstreben vor.

Um ein Herausfallen der scheibenförmigen Werkstücke aus dem Einsatz 5 beim Einführen in das Gehäuse 1 zu verhindern, werden zweckmäßig mindestens zwei der Distanzstreben 8 so angeordnet, daß ihr Abstand kleiner als der Scheibendurchmesser ist, vorzugsweise etwa dem Scheibenradius entsprechen. Dies ist insbesondere bei Einsätzen mit wenig Distanzstreben, etwa 3, wichtig. Vorteilhaft wird zumindest einer der Zwischenräume zwischen zwei Distanzstreben insbesondere dann, wenn viele Distanzstreben, beispielsweise 5 - 10, vorliegen, so groß gewählt, daß das Einführen der Scheiben möglich ist, d. h. größer als der Durchmesser runder scheibenförmigen Körper oder größer als die geringste Breite abgeflachter Scheiben oder Scheiben mit einer anderen Peripherieform. Im bevorzugten Ausführungsbeispiel der Fig. 2 liegen vier Zwischenräume vor, die kleiner als der Scheibendurchmesser sind und zwei die größer sind.

Der Einsatz wird bevorzugt so dimensioniert, daß er möglichst paßgenau, d.h. mit möglichst geringer Toleranz in das Gehäuse 1 geschoben werden kann und nur ein gewisses Spiel, nicht aber Bewegungen des Einsatzes relativ zum Gehäuse möglich sind. Die Entfernung der Distanzstreben 8 von der Achse des Gehäusezylinders 1 wird daher zweckmäßig nur geringfügig, d.h. in der Regel bis zu 4 mm kleiner als der Radius des Gehäuses gewählt. Der Einsatz kann dann bündig in das Gehäuse geschoben werden, wobei die Distanzstreben zur Abstützung des Einsatzes 5 im Gehäuse 1 dienen. In bevorzugten Ausführungsformen kann der Einsatz durch Führungen des Gehäuses, etwa Führungszapfen, in Position gehalten werden.

Durch die Distanzstreben wird eine sich nach der Zahl der zu bearbeitenden scheibenförmigen Werkstücke 6 richtende grundsätzlich beliebig große Zahl von Führungsstrebenbündeln 12, bevorzugt 10 - 20, flächig parallel und mit konstantem Abstand zueinander so verbunden, daß der Zwischenraum zwischen zwei Führungsstrebenbündeln zur Aufnahme jeweils eines scheibenförmigen Werkstücks dienen kann. Als Abstand der Führungsstrebenbündel voneinander (lichte Weite) hat sich mindestens die doppelte Scheibendicke als günstig erwiesen, zweckmäßig jedoch insbesondere ein Abstand vom 5 - 30 mm. Die Zahl der Scheiben, für die die Magazine vorgesehen wurden, wird hauptsätzlich durch Faktoren wie Wärmeentwicklung beim Ätzen, Bedienungsfreundlichkeit durch das Personal und Größe des verwendeten Bades bestimmt.

Die Verbindung der Distanzstreben 8 mit den Führungsstrebenbündeln 12 kann auf unterschiedliche Art und Weise erfolgen. Bevorzugt wird eine Verbindungstechnik gewählt, bei der möglichst wenig Ausnehmungen entstehen, da dadurch der Ablauf des flüssigen Arbeitsmediums gestört wird. Günstig hat sich beispielsweise Verschweißen, Verschrauben oder der Einsatz von Klemmnieten erwiesen.

Für die Formgebung der Führungsstreben hat sich der geknickte oder gebogene Verlauf gegenüber einem linearen, der aber nicht ausgeschlossen ist, als günstig erwiesen. Insbesondere zweckmäßig ist es, jede Strebe einfach abzuknicken, da dann ein einwandfreier Ablauf der Behandlungsflüssigkeit erfolgen kann. Um ungleichmäßige Benetzung der Scheibenoberfläche auch während der Rotation des Magazins zu vermeiden, wird vorteilhaft eine Ausführungsform gewählt, bei der alle oder zumindest die Mehrzahl der Knickstellen 14 unterschiedlich weit von der Achse des Gehäusezylinders entfernt sind. Insbesondere erscheint es günstig, als Hauptführungsstrebe einen bevorzugt etwa in der Mitte einfach um 65 - 125°, bevorzugt um 90° geknickten Stab zu verwenden, der eine Länge besitzt, die etwa dem Durchmesser des Gehäusezylinders entspricht. Die Nebenführungsstreben sind bevorzugt kürzer als die Hauptführungsstrebe, wobei die Knickstelle im Regelfall außermittig angeordnet ist. Die Knickwinkel sind bevorzugt größer als 90°, bevorzugt 100 - 160°. Die Verbindung der Haupt- und Nebenführungsstreben soll ebenfalls mit möglichst wenig Ausnehmungen erfolgen, bevorzugt sind die Führungsstrebenbündel in einem Stück gegossen oder aus einer Platte gefräst oder gesägt. Die Verknüpfungsstellen 13 der Führungsstreben untereinander werden zur Vermeidung von Unregelmäßigkeiten in der homogenen Scheibenbearbeitung unterschiedlich weit vom Zentrum des Zylinders entfernt angeordnet sein, wobei insbesondere von jeder Verknüpfungsstelle 13 die Streben nur in drei Richtungen auseinanderlaufen.

Der Querschnitt der Führungs- und Distanzstreben ist beliebig wählbar und kann beispielsweise rechteckig, rund, oval oder quadratisch sein. Jedoch hat sich wegen der besseren Ablaufeigenschaften insbesondere ein rechteckiger Querschnitt mit abgerundeten Kanten als günstig erwiesen, wobei je eine der Kanten auf eine Scheibenoberfläche zu, zwei jedoch in der Ebene der Führungsstrebenbündel lokalisiert sind.

Vorteilhaft ist es außerdem, die Führungsstreben konisch auszuführen, da auch dadurch das Abtropfen des flüssigen Mediums gefördert wird. Insbesondere ist es zweckmäßig, das verjüngte Ende des Konusses auf die Verknüpfungspunkte 13 zulaufen zu lassen. Als Grad der Verjüngung hat sich insbesondere das 0.1 - 1.0-fache des Strebendurchmessers als vorteilhaft erwiesen.

Als Material des Einsatzes und des Gehäuses haben sich Materialien als günstig erwiesen, die gegen die Reinigungs- und Ätzmittel resistent sind und nicht kontaminierend für die verwendeten Halbleitermaterialien wirken. Bevorzugt werden daher Kunststoffe, wie insbesondere Polyfluorethylen (PFA), Polytetrafluorethylen (PTFE), Tetrafluorethylen-Hexafluorpropylen-Copolymer (FEP), Ethylen-Tetrafluorethylen-Copolymer (ETFE), Ethylen-Chlortrifluorethylen-Copolymer (ECTFE), Polyvinyldifluorid (PVDF), Polychlortrifluorethylen (PCTFE) und ähnliches eingesetzt.

Zur Aufnahme eines oder mehrerer Einsätze 5 eignet sich beispielsweise ein zylinderförmiges Gehäuse 1, das zum Beispiel in der Art einer Waschmaschinentrommel an den Mantelflächen mit einer Vielzahl von Flüssigkeitsdurchlaßöffnungen 2, deren Durchmesser einen Bruchteil des Scheibendurchmessers beträgt, versehen ist. Bevorzugt sind diese Öffnungen kreisförmig.

Mindestens eine der Stirnseiten des Gehäuses 1 ist als abnehmbarer Deckel 3 ausgeführt, um die Einführung und Entnahme des Einsatzes 5 zu ermöglichen. Der Deckel 3 kann auf den Gehäusezylinder 1 gesteckt oder geschraubt werden, zweckmäßig ist jedoch, auf möglichst wenig Ausnehmungen zu achten, so daß eine Steckverbindung günstig ist.

In einer bevorzugten Ausführungsform enthält die innere Fläche des Gehäusezylinders eine Möglichkeit zur Führung des Einsatzes. Dies kann beispielsweise durch zwei Schienen parallel zur Gehäuseachse oder zwei Zapfen erfolgen, zwischen die beim Einbringen des Einsatzes eine Distanzstrebe eingeschoben wird. Beide Stirnseiten besitzen vorteilhaft dem Fachmann bekannte und üblichen Ätzanlagen angepaßte Mittel 4, wie etwa Zapfen oder Zahnkränze, um den Zylinder in einem Flüssigkeitsbad aufzuhängen und zu bewegen, insbesondere zu rotieren.

Der Wahl der Flüssigkeit, beispielsweise eines Reinigungs-, Oxidations- oder Ätzmittels, sind durch die Anwendung der Erfindung keine Grenzen gesetzt. Als Reinigungslösungen dienen beispielsweise speziell gereinigtes Wasser oder wäßrige Lösungen von Tensiden und anderen als Reinigungsmittel dienenden Stoffen. Ein solches Reinigungsverfahren ist beispielsweise in DE-A-2526052 beschrieben.

Als Ätzlösungen finden beispielsweise wäßrige Lösungen von Säuren, wie beispielsweise Gemische von Fluß- und Salpetersäure, die zur weiteren Steuerung des Ätzprozesses noch Zusätze enthalten können, aber auch alkalische Lösungen Verwendung. Insbesondere kommen auch Lösungen zur Anwendung, die Wasserstoffperoxid oder Ozon enthalten. Für die Anwendung der Erfindung können die üblichen, dem Fachmann bekannten Bedingungen, wie Temperatur- und Druckbereiche sowie zeitliche Dauer, unter welchen Reinigungs-, Oxidations- und Ätzprozesse vollzogen werden, beibehalten werden.

Typischerweise wird zur Verwendung des Magazins der Einsatz mit der durch die Zahl der Führungsstrebenbündel festgelegten Anzahl von scheibenförmigen Werkstücken beladen. Der Einsatz wird in das einseitig geschlossene Gehäuse geschoben und die offene Stirnseite des Gehäuses mit dem stirnseitigen Deckel verschlossen. Das Gehäuse mit eingeschobenem Einsatz wird durch die Haltevorrichtungen 4 an der Transportvorrichtung einer handelsüblichen Ätzanlage befestigt und in das Reinigungs- oder Ätzbad gebracht, das gegebenenfalls auch aufgeheizt oder nach Verschließen unter Druck gesetzt werden kann.

Eine gleichmäßige Behandlung der Substratoberfläche mit der Reinigungs- oder Ätzlösung kann zum Beispiel erreicht werden, wenn die Stoffaustauschgeschwindigkeiten an der Phasengrenze fest/flüssig auf der gesamten Substratoberfläche möglichst gleich sind, d.h. gelöste Teilchen möglichst schnell von der Substratoberfläche entfernt werden, die gebrauchte Lösung somit gleichmäßig und schnell durch frische Lösung ersetzt wird und die Halterung, durch die das Substrat in die Lösung eingeführt wird, einen möglichst geringen Teil der Oberfläche möglichst kurze Zeit oder gleichmäßig bedeckt, so daß sich dadurch keine Unregelmäßigkeiten im Ätzvorgang ergeben.

Das an der Haltevorrichtung aufgehängte Magazin wird daher bevorzugt völlig in die Reinigungs- oder Ätzlösung eingetaucht und in dieser bewegt, vorzugsweise rotiert, insbesondere unter Drehrichtungswechsel. Durch die Durchlaßöffnungen 2 wird dabei ständig die im Inneren des Gehäuses befindliche Lösung durch frische Lösung aus dem Vorrat des Reinigungs- oder Ätzbades ersetzt. Im Innern des Gehäuses sorgen die Führungsstreben bei der Bewegung des Gehäuses für eine kontinuierliche Umschichtung und Durchrührung der Lösung, so daß die Scheiben gleichmäßig umspült werden. Durch die Bewegung wird darüberhinaus die Position der Scheiben relativ zu den Führungs- und Distanzstreben verändert, wodurch eine ständige Veränderung der Auflagepunkte der Scheiben erfolgt und damit der Austausch der Behandlungsflüssigkeit über der gesamten Scheibenoberfläche konstant bleibt. Da die Verknüpfungsstellen der Führungsstreben unterschiedlich weit vom Gehäuse und von der Zylinderachse entfernt sind, kommen diese Punkte bei der Rotation ständig mit unterschiedlichen Punkten der Scheibenoberfläche in Berührung, womit wieder eine unterschiedliche Scheibenbenetzung vermieden wird, die erfahrungsgemäß zu ringförmigen Unebenheiten führt. Da die lichte Weite zwischen den Führungsstrebenbündeln ein Vielfaches der Scheibendicke beträgt, liegen die Scheiben im Regelfall auch gekippt im Magazin auf, so daß lediglich der Rand als Auflagefläche dient.

Nach der vorgeschriebenen Behandlungszeit wird das Magazin mit Hilfe der Transportvorrichtung aus dem Bad gehoben. Dabei verläßt die Reinigungs- oder Ätzlösung durch die Durchlaßöffnungen 2 das Gehäuse des Magazins. Durch die Knickstellen und die bevorzugt konische Form der Führungsstreben ist dabei in vorteilhafter Weise für eine bessere Tropfenbildung und ein schnelleres Ablaufen der Lösung gesorgt.

Der beschriebene Vorgang kann mit unterschiedlichsten Reinigungs- und Ätzbädern beliebig oft wiederholt werden, ohne daß eine Öffnung des Magazingehäuses erfolgen muß.

Die Vorteile der erfindungsgemäßen Vorrichtung zur Halterung von scheibenförmigen Werkstücken beruhen darauf, daß die zur Halterung notwendigen Auflageflächen nicht nur möglichst klein gehalten werden und am Rand der Scheiben lokalisiert sind, sondern während des Behandlungsvorgangs möglichst häufig wechseln, so daß ein möglichst großer Teil der Oberfläche der Halbleiterscheiben eine gleichmäßig lange Zeit mit der Lösung in Berührung kommt. Der Kontakt mit dem Halbleitermaterial wird auf ein Minimum beschränkt und durch die Form der Führungsstreben über die gesamte Oberfläche verteilt, so daß keine lokal unterschiedlichen Ätzraten auftreten.

Die Bildung von Ebenheits- und Parallelitätsfehlern kann dadurch weitestgehend ausgeschlossen werden, daß die Strömungsverhältnisse und der Stoffaustausch innerhalb der Kammern des drehbaren, zylinderförmigen Reaktionskorbes durch die Einführung der speziell geformten Führungsstreben verbessert wurden. Dadurch wird die Umschichtung der Lösung von der Zone am Rand der Scheibe auf das gesamte Volumen im Innern des Gehäuses ausgedehnt. Von außerhalb des Gehäuses können die Lösungen bei dessen Bewegung darüberhinaus ständig ausgetauscht werden. Die vorzugsweise gewinkelte und viereckige Ausführung der Führungsstreben führt zu einem leichten Ablauf der Behandlungslösungen nach Entfernen der Magazine aus dem Bad, so daß eine ungleichmäßige Bearbeitung der Scheiben durch verbleibende Lösungsreste vermindert wird.

Die Verwendung der Erfindung beim Ätzen von Halbleiter-, insbesondere Siliciumscheiben, zum Beispiel im sauren Medium mit Gemischen aus oxidischen Säuren und HF mit Zusätzen führt dazu, daß die Verschlechterung der Geometrie der Scheiben, die mit herkömmlichen Magazinen häufig beobachtet wurde, stark reduziert werden kann. Beispielsweise konnten die Ebenheits- und Parallelitätsfehler, die zuvor beim Ätzen beobachtet wurden, stark verringert werden. Beispielsweise verbesserte sich die Total Thickness Variation (TTV), d. h. der Absolutbetrag der Differenz des maximalen und minimalen Dickenwertes der gesamten Scheibenfläche, die zuvor im Bereich von 5 bis 10 »m lag, auf weniger als 1 »m.

## Patentansprüche

1. Magazin zur Halterung von scheibenförmigen Werkstücken (6), insbesondere Halbleiterscheiben, bei der naßchemischen Oberflächenbehandlung in Flüssigkeitsbädern, mit
einem zylindrischen Gehäuse (1) mit Öffnungen (2) zum Ein- und Austritt der Flüssigkeit und Mitteln (4) zur Einbringung in ein Flüssigkeitsbad
und einem in das Gehäuse (1) einführbaren Einsatz (5) zur Halterung der zu behandelnden Werkstücke in unmittelbarer, dichter flächiger Gegenüberstellung im Gehäuse, gekennzeichnet durch den Einsatz (5) mit
a) mindestens drei parallelen, jeweils eine Ebene aufspannenden Führungsstrebenbündeln (12), jedes bestehend aus mindestens zwei Führungsstreben (7), nämlich einer Hauptführungsstrebe (9) und einer mit ihr verknüpften Nebenführungsstrebe (10), und
b) mindestens drei Distanzstreben (8), die paßgerecht zur Innenfläche des Gehäusezylinders angeordnet sind, und die die mindestens drei Führungsstrebenbündel am äußeren, dem Gehäuse zugewandten Ende der Führungsstreben so fixieren, daß die Zwischenräume zwischen den Ebenen der Führungsstreben bündel die Aufnahme der zu halternden scheibenförmigen Werkstücke gestatten,
wobei je Führungsstrebenbündel mindestens eine Hauptführungsstrebe (9) zwei Distanzstreben verbindet und mindestens eine Nebenführungsstrebe (10) die Hauptführungsstrebe mit einer weiteren Distanzstrebe verbindet, und die Mehrzahl der Führungsstreben geknickt oder gebogen sind,
c) an den Verknüpfungsstellen (13) die Führungsstreben in höchstens drei Richtungen auseinanderlaufen,
d) die Verknüpfungsstellen der Führungsstreben nicht auf der Längsachse des zylindrischen Gehäuses liegen,
e) der Durchmesser des Einsatzes 1,1 bis 1,9 mal dem Durchmesser der zu halternden scheibenförmigen Werkstücke entspricht,
f) der Abstand benachbarter Distanzstreben zwischen mindestens zwei der Distanzstreben größer oder gleich dem Durchmesser der zu halternden scheibenförmigen Werkstücke ist und zwischen mindestens zwei der Distanzstreben kleiner als der Radius der zu halternden Werkstücke ist, und
g) die innere lichte Weite zwischen zwei Führungsstrebenbündelebenen mindestens zweimal der Dicke der zu halternden scheibenförmigen Werkstücke entspricht.

2. Magazin nach Anspruch 1, dadurch gekennzeichnet, daß das Gehäuse und der Einsatz aus gegenüber den verwendeten Flüssigkeiten resistentem Material gefertigt sind.

3. Magazin nach Anspruch 2, dadurch gekennzeichnet, daß als Material einer oder mehrere Kunststoffe aus der Gruppe von Tetrafluorethylen-Hexafluorpropylen-Copolymerisat (FEP), Ethylen-Tetrafluorethylen-Copolymer (ETFE), Ethylen-Chlortrifluorethylen-Copolymer (ECTFE), Polychlortrifluorethylen (PCTFE), Polyvinylidendifluorid (PVDF), Polyfluorethylen (PFA) sowie Polytetrafluoroethylen (PTFE) verwendet werden.

4. Magazin nach einem oder mehreren der Ansprüche 1-3, dadurch gekennzeichnet, daß die Fixierung von Führungsstreben und Distanzstreben miteinander durch Verschweißen oder Verschrauben erfolgt.

5. Magazin nach einem oder mehreren der Ansprüche 1-4, dadurch gekennzeichnet, daß die Führungsstreben einen vierkantigen Querschnitt mit abgerundeten Kanten besitzen, wobei mindestens eine der Kanten in Richtung der Oberfläche des Werkstücks (6) gerichtet ist.

6. Magazin nach einem oder mehreren der Ansprüche 1-5, dadurch gekennzeichnet, daß 6 Distanzstreben, eine Haupt- und vier Nebenführungsstreben vorliegen.

7. Magazin nach einem oder mehreren der Ansprüche 1-6, dadurch gekennzeichnet, daß jede der Führungsstreben eine Knickstelle mit einem Winkel von 70 - 160 Grad besitzt und daß die Knickstellen unterschiedlich weit von der Befestigung der Führungsstrebe an der Distanzstrebe entfernt sind, wobei vorzugsweise der Knickwinkel der Hauptführungsstrebe größer als 90 Grad ist.

8. Magazin nach Anspruch 7, dadurch gekennzeichnet, daß die Knickstelle der Hauptführungsstrebe in der Mitte der Strebe angeordnet ist.

9. Magazin nach einem oder mehreren der Ansprüche 1-8, dadurch gekennzeichnet, daß die Verknüpfungsstellen (13) der Führungsstreben unterschiedlich weit von der Verknüpfungsstelle der jeweiligen Distanzstrebe mit der Führungsstrebe entfernt sind.

10. Magazin nach einem oder mehreren der Ansprüche 1-9, gekennzeichnet dadurch, daß die Nebenführungsstreben sich konisch verjüngen.

11. Verwendung von Magazinen nach einem oder mehreren der Ansprüche 1 - 10 zur Behandlung von Halbleiterscheiben mit Flüssigkeiten.

12. Verwendung von Magazinen nach einem oder mehreren der Ansprüche 1 - 10 zur Ätzbehandlung von Halbleiterscheiben.

## Claims

1. Magazine for holding disc-type workpieces (6), in particular semiconductor wafers, during wet-chemical surface treatment in liquid baths, comprising
a cylindrical housing (1) having openings (2) for inlet and outlet of the liquid and means (4) for introducing it into a liquid bath
and an insert (5) which can be introduced into the housing (1) for holding the workpieces to be treated directly, closely and flatly opposite one another, characterized by the insert (5) comprising
a) at least three parallel guide strut assemblies (12) each defining a plane, each comprising at least two guide struts (7) namely a main guide strut (9) and a subsidiary guide strut (10) linked to it, and
b) at least three spacing struts (8) which are arranged so as to precisely fit the inside surface of the housing cylinder and which fix the at least three guide strut assemblies at the outer end, facing the housing, of the guide struts so that the gaps between the planes of the guide strut assemblies permit the reception of the disc-type workpieces to be held, at least one main guide strut (9) per guide strut assembly connecting two spacing struts and at least one subsidiary guide strut (10) connecting the main guide strut to a further spacing strut and the majority of the guide struts being folded or bent,
c) the guide struts diverging at the linking points (13) in not more than three directions,
d) the linking points of the guide struts not lying on the longitudinal axis of the cylindrical housing,
e) the diameter of the insert corresponding to 1.1 to 1.9 times the diameter of the disc-type workpieces to be held,
f) the spacing of adjacent spacing struts between at least two of the spacing struts being greater than or equal to the diameter of the disc-type workpieces to be held and between at least two of the spacing struts being smaller than the radius of the workpieces to be held, and
g) the inner clear distance between two guide strut assembly planes corresponding to at least twice the thickness of the disc-type workpieces to be held.

2. Magazine according to Claim 1, characterized in that the housing and the insert are manufactured from material which is resistant to the liquids used.

3. Magazine according to Claim 2, characterized in that one or more plastics from the group comprising tetrafluoroethylene-hexafluoropropylene copolymer (FEP), ethylene-tetrafluoroethylene copolymer (ETFE), ethylenechlorotrifluoroethylene copolymer (ECTFE), polychlorotrifluoroethylene (PCTFE), polyvinylidene difluoride (PVDF), polyfluoroethylene (PFA) and also polytetrafluoroethylene (PTFE) are used as material.

4. Magazine according to one or more of Claims 1-3, characterized in that guide struts and spacing struts are fixed to one another by welding or screwing.

5. Magazine according to one or more of Claims 1-4, characterized in that the guide struts have a square cross section with rounded edges, at least one of the edges being directed in the direction of the surface of the workpiece (6).

6. Magazine according to one or more of Claims 1-5, characterized in that there are 6 spacing struts, one main guide strut and four subsidiary guide struts.

7. Magazine according to one or more of Claims 1-6, characterized in that each of the guide struts has a kink having an angle of 70-160 degrees, and in that the kinks are at varying distances from the fixing of the guide strut to the spacing strut, the kink angle of the main guide strut preferably being greater than 90 degrees.

8. Magazine according to Claim 7, characterized in that the kink in the main guide strut is arranged in the centre of the strut.

9. Magazine according to one or more of claims 1-8, characterized in that the linking points (13) of the guide struts are at varying distances from the linking point of the relevant spacing strut and the guide strut.

10. Magazine according to one or more of Claims 1-9, characterized in that the subsidiary guide struts are conically tapered.

11. Use of magazines according to one or more of Claims 1-10 for treating semiconductor wafers with liquids.

12. Use of magazines according to one or more of Claims 1-10 for the etching treatment of semiconductor wafers.

## Revendications

1. Magasin pour la fixation de pièces usinées (6) en forme de disque, plus particulièrement de disques de semiconducteurs, au cours du traitement de surface par voie chimique humide dans des bains de liquides, comportant
une cage cylindrique (1) munie d'orifices (2) pour l'entrée et la sortie du liquide et des moyens (4) pour l'introduction dans un bain liquide,
une garniture (5) pour fixer les pièces usinées à traiter, que l'on peut introduire dans la cage (1) dans une position compacte immédiatement contre la surface de la cage, caractérisé en ce que la garniture (5) comportent
a) au moins trois faisceaux parallèles d'arcs-boutants de guidage (12) se développant chacun dans un plan, chaque faisceau étant composé d'au moins deux arcs-boutants de guidage (7), notamment d'un arc-boutant de guidage principal (9) et d'un arc-boutant de guidage latéral (10) relié à l'arc-boutant principal.
b) au moins trois arcs-boutants d'espacement (8) qui sont disposés de façon appropriée contre les parois intérieures du cylindre de la cage, et qui maintiennent au moins les trois faisceaux d'arcs-boutants de guidage sur l'extrémité extérieure tournée vers la cage de l'arc-boutant de guidage de telle sorte, que les espaces entre les plans des faisceaux d'arcs-boutants de guidage permettent la réception des pièces usinées en forme de disque à fixer,
chaque faisceau d'arcs-boutants de guidage reliant au moins un arc-boutant de guidage principal (9) à deux arcs-boutants d'espacement et à au moins un arc-boutant de guidage latérale (10), lequel relie l'arc-boutant de guidage principal à un autre arc-boutant d'espacement,
et la majorité des arcs-boutants de guidage étant pliés ou courbés,
c) en ce que aux points d'assemblage (13), les arcs-boutants de guidage partent au plus dans trois directions,
d) en ce que les points d'assemblage des arcs-boutants de guidage ne sont pas situés sur l'axe longitudinal de la cage cylindrique,
e) en ce que le diamètre de la garniture est de 1,1 à 1,9 fois le diamètre des pièces usinées sous forme de disque à fixer,
f) en ce que la distance entre les arcs-boutants d'espacement voisins, entre au moins deux des arcs-boutants d'espacement est supérieure ou égale au diamètre des pièces usinées en forme de disque à fixer et entre au moins deux des arcs-boutants d'espacement, inférieure au rayon des pièces usinées à fixer, et
g) en ce que la distance intérieure entre deux plans de faisceaux d'arcs-boutants de guidage correspond à au moins le double de l'épaisseur de la pièce usinée en forme de disque à fixer.

2. Magasin selon la revendication 1, caractérisé en ce que la cage et la garniture sont fabriquées en matériau résistant aux liquides utilisés.

3. Magasin selon la revendication 2, caractérisé en ce qu'on utilise en tant que matériau une ou plusieurs matières plastiques prises dans le groupe comprenant les copolymère du tétrafluoro-éthylène/hexafluoropropylène (FEP), copolymère de l'éthylène/tétrafluoro-éthylène (ETFE), copolymère de l'éthylène/chlorotrifluoroéthylène (ECTFE), polychlorotrifluoroéthylène (PCTFE), difluorure de polyvinylidène (PVDF), polyfluoroéthylène (PFE) ainsi que poly(tétrafluoroéthylène) (PTFE).

4. Magasin selon une ou plusieurs des revendications 1 à 3, caractérisé en ce qu'on réalise l'assemblage des arcs-boutants de guidage et des arcs-boutants d'espacement par soudage ou par vissage.

5. Magasin selon une plusieurs des revendications 1 à 4, caractérisé en ce que les arcs-boutants de guidage ont un profil carré à bords arrondis, au moins un des bords étant orienté en direction de la surface de la pièce usinée (6).

6. Magasin selon une ou plusieurs des revendications 1 à 5, caractérisé en ce qu'il comporte six arcs-boutants d'espacement, un arc-boutant de guidage principal et quatre arcs-boutants de guidage latéraux.

7. Magasin selon une ou plusieurs des revendications 1 à 6, caractérisé en ce que chacun des arcs-boutants de guidage comporte un point de pliage ayant un angle de 70 à 160 degrés, et que les points de pliage sont différemment éloignés du point de fixation de l'arc-boutant de guidage sur l'arc-boutant d'espacement, l'angle de pliage de l'arc-boutant de guidage principal étant de préférence supérieur à 90 degrés.

8. Magasin selon la revendication 7, caractérisé en ce que le point de pliage de l'arc-boutant de guidage principal est disposé au centre de l'arc-boutant.

9. Magasin selon une ou plusieurs des revendications 1 à 8, caractérisé en ce que les points d'assemblage (13) des arcs-boutants de guidage sont disposés à des distances différentes du point d'assemblage de l'arc-boutant d'espacement correspondante avec l'arc-boutant de guidage.

10. Magasin selon une ou plusieurs des revendications 1 à 9, caractérisé en ce que les arcs-boutants de guidage latéraux sont effilés en cônes.

11. Utilisation des magasins selon une ou plusieurs des revendications 1 à 10, pour le traitement de disques de semiconducteurs par des liquides.

12. Utilisation des magasins selon une ou plusieurs des revendications 1 à 10, pour le décapage à l'acide des disques de semiconducteurs.
